# EUROPEAN PATENT APPLICATION

(11) **EP 2 940 178 A1**
(43) Date of publication of application: **04.11.2015**
(21) Application number: 13867666.3
(22) Date of filing: 30.09.2013
(51) Int. Cl.: C23C 14/08, C23C 14/35, C23C 14/06, C23C 14/36

(54) **METHOD FOR PREPARING AL2O2 COATING ON SURFACE OF SILICON -NITRIDE -CUTTING TOOL BY USING PVD,AND COMPOSITE COATING METHOD**

(30) Priority: 26.12.2012 US 201261745871 P
(71) Applicant: Wu, Shanghua, Guangzhou, Guangdong 510006 (CN)
(72) Inventor: LONG, Ying, Guangzhou Guangdong 510006 (CN); WANG, Qimin, Guangzhou Guangdong 510006 (CN); WANG, Chengyong, Guangzhou Guangdong 510006 (CN)
(74) Representative: Petraz, Gilberto Luigi
(86) International application number: PCT/CN2013/084753
(87) International publication number: WO 2014/101517

(57) **Abstract**

A method for preparing an aluminum-oxide single-layer coating or multi-layer coating on the surface of silicon-nitride ceamic cutting tool by using a Physical Vapor Depositon (PVD) process. There are two methods for preparing the aluminum-oxdie coating by using the PVD techonology: one is depositing an aluminum-oxide layer through reactive sputtering of Al target by using a bipolar pulse power source and a Dual Magnetron Sputtering (DMS) technology in the O₂ atmosphere or Ar-O₂ mixed atmosphere; the other one is sputtering, by using DMS technology in the Ar atmosphere or Ar-O₂ mixed atmosphere, an aluminum-oxide ceramic target conductive doping, and then preparing the aluminum-oxide coating. With the two methods, a single-layer aluminum-oxide coating, a nitride and aluminum-oxide composite coating, or a multi-layer or nano composite coating obtained by alternately depositing nitride and alumimum oxide is prepared, the aluminum-oxide being α-Al₂O₃, β-Al₂O₃, γ-Al₂O₃, or amorphous Al₂O₃. The hard nitride coating in the multi-layer composite aluminum-oxide coating comprises a two-element nitride coating, a three-element nitride coating, multi-element nitride coating, or a multi-layer composite thereof of a nano coating.

## Description

### FIELD OF THE INVENTION

The present invention relates to coated ceramic cutting tools, and particularly, to Si₃N₄-based cutting tools having at least a layer of Al₂O₃ coating formed by PVD method.

### BACKGROUND OF THE INVENTION

With high resistance high temperature, wear, superior hot hardness and chemical stability, ceramic cutting tools can be used to machine extremely hard and wear-resistant materials. These unique mechanical properties can allow ceramic cutting tools to be used to machine metals at much higher cutting speeds than the carbide tools even in dry machining conditions. The most commonly used ceramic materials for cutting tools are alumina and silicon nitride. Alumina based materials are excellent candidates for cutting tools because of their good chemical stability and abrasion resistance at high temperature. However, intrinsic brittleness, low strength and low thermal shock resistance of the alumina based ceramic cutting tools limit their applications. Silicon nitride based cutting tools, which have good wear resistance, high hardness, excellent high-temperature properties, and most importantly, better fracture toughness than the alumina based cutting tools, are widely used in machining metals, more particularly for machining cast iron at high speeds.

However, in high speed machining cast iron using Si₃N₄ tools under dry cutting conditions, when the cutting speed exceeds 1500 surface feet per minute (sfm), the temperature at contact faces of the cutting inserts may be over 1000 °C due to the heat generated by dramatic friction between the cutting tools and the workpiece. The chemical reaction between silicon nitride and iron would reduce the stablity of the cutting tools. In addition, serious diffusion-related crater wear can be usually observed in this application. This crater wear is believed resulting from the chemical affinity between Si₃N₄ elements and iron alloy components that promotes tribo-chemical reactions. During high speed machining, tipping failure may occur due to local chemical wear Therefore, chemical stablity of the cutting tool material is very important under high-speed, dry machining conditions.

Covering the Si₃N₄ based ceramic cutting tools with thin films is a feasible method to improve chemical stability. Until now, various coatings have been successfully applied on cutting tools and inserts where the tool materials are high speed steels or cemented carbide, from single, binary coatings to complex multi-component and multi-layer configurations. Among them, the most commonly used coating materials for cutting tools are transition metal nitrides, such as TiN and TiAlN. TiN coating is good for protecting cutting tools due to its high hardness and wear resistance. However, the application of TiN coating is limited to low temperatures since it tends to be oxidized at temperatures above 600°C. The oxidation resistance of TiAlN coating is much higher than that of TiN with the formation of a dense and strongly adhesive Al₂O₃. Although the oxidation temperature of TiAlN coating can be improved to 800°C, it is still not good enough for high-speed cutting with temperatures over 1000°C. Al₂O₃ has excellent wear resistance, high hot hardness and chemical stability at elevated temperatures above 1000 °C . Having such various advantages, Al₂O₃ is a good candidate material for protective coating(s) on cutting tools to improve their productivity of machining operations, especially at high temperature under high-speed and dry machining conditions.

The most commonly used methods for producing coating layers on cutting tools are chemical vapor deposition (CVD) and physical vapor deposition (PVD). So far, due to the requirement for high deposition temperature and insulating attribute of Al₂O₃, the mostly used technique for producing Al₂O₃ and their multi-layered coatings is chemical vapor deposition (CVD). For Si₃N₄ cutting tools which are also insulating, the main technique to produce Al₂O₃ coating(s) is also CVD method. However, the CVD processes are normally operated at temperatures in excess of 1000°C, due to the high deposition temperatures, coatings produced by CVD technique have thermal cracks, due to thermal stresses caused by the thermal expansion mismatch between the coating and the substrate as the tool is cooled down from the processing temperature to the room temperature. During cutting process, the thermal crack may lead to breakage of the coating or chipping.

Over the last 30 years, the introduction of PVD coatings for cutting tools in the metal cutting industry is one of the main success stories in the industrial application of modern coating technology. The first PVD coating material for commercial application on cutting tools was TiN in the early 1980s. Since the 1990s most cutting tools have been PVD coated particularly in applications where sharp edges are required, e.g. threading, grooving, end-milling, etc. and in cutting applications that have a high demand for a tough cutting edge, e.g. drilling.

Several PVD techniques have been developed so far. For the application of coatings on cutting tools, the mainly used techniques are: cathodic arc deposition (or called arc ion plating), sputter deposition (or called magnetron sputtering), pulsed laser deposition and electron beam physical vapor deposition. One of the PVD methods to produce insulating films is radio frequency (RF) sputtering. This method can produce highly uniform films with good adherence to the substrate. However, extremely low deposition rate caused by the small DC-voltage which is generated at the target and ever growing technique problems for increasing substrate sizes have limited the use of these layers to a few applications because of the high coating costs.

Another way, the DC sputtering, the which is used to grow oxides, nitrides and carbides due to the simplicity of the process, and it can forms aluminum flims in a reactive argon-oxygen gas mixture. But this method cannot be performed as a stable long-term mode. Because the insulating layers are deposited not only on the substrate but equally on the chamber walls and on regions of the sputter targets. Here electric charges will occur that, in turn, result in arcing and therefore in a damage of the layers.

The utilization of bipolar pulsed power on the cathode enables deposition of insulation coating without target poisoning and arcing. And the deposition rate can be enhanced as compared with RF sputtering. By utilizing the bipolar pulsed power (i.e., alternatively applying a positive and negative voltage), the surface is continuously discharged. The effect of the positive pulse is to draw electrons in the plasma toward the target where they can neutralize the accumulated Ar⁺ ions. If the pulse duration (pulse width) and the height of the positive pulse are just enough to produce an electron current that can discharge all the accumulated Ar⁺ ions on the target, the repelling effect on the incoming Ar⁺ ions when the target voltage turns negative is eliminated. This keeps the sputtering process going and the discharge plasma can be self-maintaining. Furthermore, application of the positive pulse can lead to preferential sputtering of the poisoned spots on the target. This helps to eliminate target poisoning and arcing. Therefore, reactive magnetron sputtering deposition of oxide compounds or sputtering deposition of oxide compounds such as Al₂O₃, ZrO₂, TiO₂, and ZnO, is enabled by the introduction of bipolar pulsed-dc power on the sputtering cathode.

With the invention and development of the bipolar pulsed DMS (Dual Magnetron Sputtering) technique, it becomes possible to produce crystalline insulating layers such as Al₂O₃ by PVD methods. In the bipolar dual magnetron system, two magnetrons alternately act as anode and cathode and, hence, preserve a metallic anode over long process times. Bipolar pulsed dual magnetron sputtering enables high power input into the plasma during the pulsed, thus creating dense plasma with highly energetic particles. When the frequencies are high enough, possible electron charging on the insulating layers will be suppressed and the otherwise troublesome phenomenon of "arcing" will be limited.

The bipolar pulsed DMS technique provides wide opportunities for depositing and producing high-quality, well-adherent, α-Al₂O₃ thin hard films on cutting tools. In addition, the technique involves stable process conditions within a large process window as compared to other sputtering techniques, as well as high deposition rate for insulating coatings such as Al₂O₃. According to US 6,673,430 B2 and US 6,423,403 B2, a γ-Al₂O₃ layer with grain size less than 0.1 µm and free of cracks and halogen impurities is deposited utilizing a DMS technique at substrate temperatures in the range 450°C to 700°C, preferably at 550°C to 650°C.

Another possible PVD method for depositing Al₂O₃ coatings on cutting tools is by the present invention of dual magnetron sputtering metal-doped conductive Al₂O₃ ceramic targets in an Ar gas or Ar+O₂ atmosphere. In this technique, the nonconductive Al₂O₃ ceramic is doped by metals such as Al, Ti, Cr, Nb, Pt or conductive ceramics such as SiC. The conductive doped Al₂O₃ ceramic target is used as cathode applied with an asymmetrical bipolar pulsed power. Both of these two techniques had not been utilized previously for depositing Al₂O₃ coating layers on Si₃N₄-based cutting tools.

### BRIEF SUMMARY OF THE INVENTION

The purpose of the present invention is offering a fabrication technique of the coating, especially for the fabrication coating method on the surface of the Si3N4-based ceramic cutting tools.

The cutting tool with coating in the present invention consists of the Si3N4 ceramic substrate and the coating on the surface, which has at least one Al2O3 coating layer consisting of amorphous Al2O3 or nanocrystalline α-, γ-, or κ- Al2O3.

Since the Si3N4-based ceramics are not electrically conductive, they are difficult to be coated with protective ceramic layers by conventional PVD technique. The first technical problem of this invention to solve is to produce coating(s) by PVD technique on Si3N4-based ceramic substrates which are electrically insulating.

The second technical problem of this invention to solve is to produce electrically insulating Al2O3 coating(s) on Si3N4-based ceramic substrates by PVD technique.

The third technical problem of this invention to solve is to improve the performance of Al2O3 coating(s) or Al2O3-containing coating(s) on Si3N4-based ceramic cutting tools under high-speed, dry machining conditions for machining cast iron or other hard materials.

The Si3N4-based ceramic is the cutting tool substrate in present invention, which possess excellent wear resistance, high hardness, and good high temperature properties and fracture toughness.

The Si3N4-based ceramic contains 0.1wt-5wt% oxide additives (one or several), such as Si02, A1203, MgO, Y203, Zr02 and ReO (rare-earth oxide, e.g. La203).

The Si3N4-based ceramic contains 0.1wt-5wt% conductive additives (one or several) such as TiC, TiN, TiCN, SiC, MoSi, TiB2, and MoSi+SiC etc., so that the ceramic can be tailored to be conductive and the coatings can be deposited on them by the conventional PVD methods.

Three kinds of coatings are provided according to the present invention: single-layer Al2O3 coating; multilayer coating consisting of a hard nitride layer and an Al2O3 coating layer; multilayered or nanolayered coatings consisting of alternating thin layers of hard nitride layer and Al2O3 coating layer.

The hard nitride layer is binary nitride (TiN, CrN, etc.), ternary nitride (TiCN, TiAIN, etc.), or multi-components nitride (TiAlSiN, TiAlCrYN, etc.) layers or their multi-layers or nano layers.

The PVD technique includes reactive sputtering by bipolar pulsed DMS technique or dual magnetron sputtering conductive Al2O3 ceramic target technique.

According to the bipolar pulsed DMS technique, the Al2O3 coating layer is deposited utilizing reactive sputtering of Al cathode in an 02 gas or a gas mixture of Ar and 02 with process pressure of 0.1-2 Pa at substrate temperature of 300-700°C by bipolar pulsed DMS technique.

According to dual magnetron sputtering conductive Al2O3 ceramic target with conductive materials additive, the Al2O3 coating layer is deposited by sputtering conductive Al2O3 ceramic target in an Ar gas or a gas mixture of Ar and 02 with process pressure of 0.1-2 Pa at substrate temperature of 300-700°C.

In the conduction of electricity dopant Al2O3 ceramic target, the content of conductive metal (such as Al, Ti, Cr, Nb, and Pt) or conductive ceramic (such as SiC) is 0.3-20wt%.

According to the cutting tool coating, the function of the Al2O3 is isolating the Si3N4-based ceramic cutting tool with oxygen and the activity elements in the workpieces.

According to the cutting tool coating, the function of the hard nitride layer is providing excellent bonding force of film as cohesion buffer layer, and offering good thermal resistance and wear resistance for cutting tool system.

According to the cutting tool coating, the mechanical properties at high temperatures of the Si3N4-based ceramic cutting tool/cutting tool substrate can be ensured.

The cutting tool with coating in the present invention can effectively apply on turning cast iron alloy, converted steel, and high temperature nickel-based alloy in high speed and dry environment, especially for the rough and finish machining of turning and milling.

### BRIEF DESCRIPTION OF THE DRAWINGS

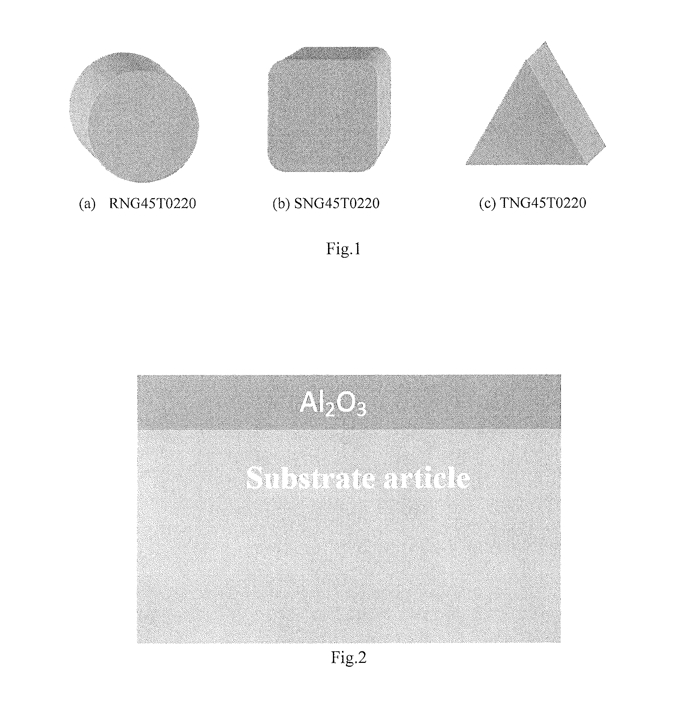

Figure 1 shows the structure schematic diagram of the ceramic cutting tool which the present invention produced: (a) Cylindrical RNG45T0220; (b) Tetragonal SNG45T0220 and (c) Triangle TNG45T0220.
Figure 2 is a schematic diagram of a single-layer alumina coating on the Si3N4 cutting tool.

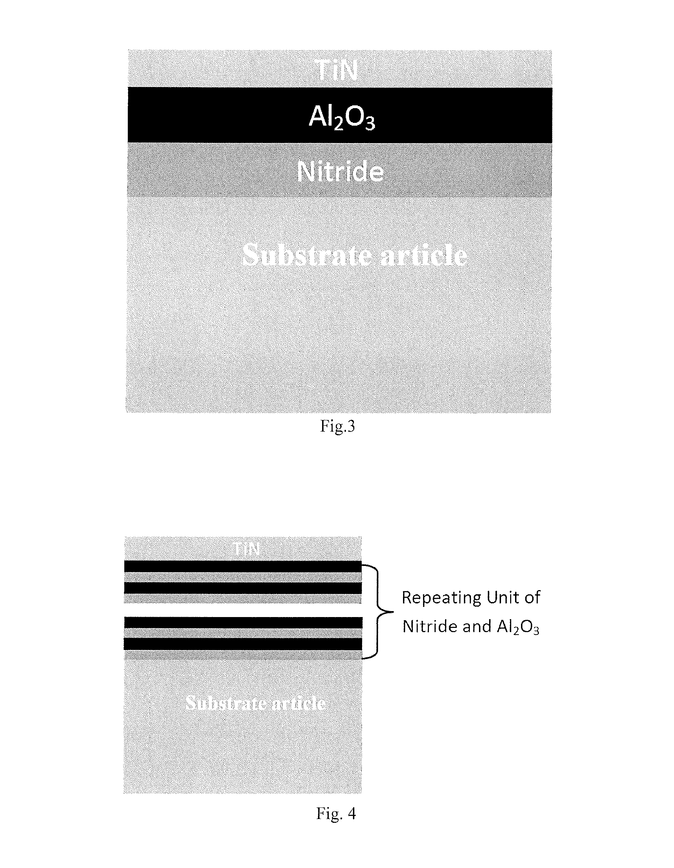

Figure 3 is a schematic diagram of a triple-layer coating consisting of a Si3N4 inner-layer, an middle Al2O3 coating layer, and a outer TiN layer.
Figure 4 is a schematic diagram of a multilayer or nanolayered coating with at least 4 layers composed of alternating thin layers of nitride layer, Al2O3 coating layer, and a TiN top layer.

### DETAILED DESCRIPTION OF THE INVENTION

The present invention is Si3N4-based ceramic, which mainly consists of Si3N4, including toughening additives and sintering additives. The toughing additive(s) is (are) one or several compound(s) in TiN, TiC, MoSi2, SiC, TiCN, And TiB2 etc. and the sintering additives(s) is (are) one or several compound(s) in Si02, A1203, MgO, Y203, Zr02, and La203 etc.. The content of sintering additives is general about 1-25wt%, and the optimal content is 1-5wt%. It can improve the strength, fracture toughness, and the property of wear resistance of the substrate materials to a great extent by adding toughening additives and sintering additives. In addition, through adding conductive phase, the composite ceramic can conduct of electricity, so the hard coating can be deposited on them by the conventional PVD methods.

### Enfolded hard coating

In the present invention, the coating includes one or more layers of which at least one layer is Al2O3 coating. The A1203 layer is mainly composed of Al and O. According to different depositing temperature, the phase structure can be amorphous or nanocrystalline α-, γ-, or κ- A1203, or the mixture of amorphous and nanocrystalline. The other coatings are high temperature resistance hard nitride coatings (if exist), which may be binary nitride (TiN, CrN, etc.), ternary nitride (TiCN, TiAIN, etc.), or multi-components nitride (TiSiN, TiAISiN, TiAlCrYN, etc.), and it also may be their multi-layers or nano-composite layers. The whole thickness of the coating in the present invention is general about 1-20 µm, the optimal thickness is 2-10µm. This mainly because when the thickness of the coating falls below 1 µm, the coating may have poor wear resistance and may be easily worn out during cutting process. Thus, the cutting performance and tool life of the cutting tools cannot be improved. However, when the coating thickness is over 20 µm, the adhesion strength between the substrate and the coating material becomes weak due to high compressive residual stress and the coating may crack or spall off from the substrate or even be damaged. This may shorten the life of the cutting tools. The thickness of the coating layers can be adjusted by controlling the deposition time.

In the present invention the cutting tool coating is fabricated by PVD technique. Before coating deposition, the surfaces of the substrate are plasma cleaned and etched by plasma etching utilizing a high-frequency bipolar pulsed bias voltage or an ion source plasma etching equipment for 2-60 min, the optimal etching time of which is 5-30 min. The surface is smooth and then after wet/dry blasting and cleaned, moved into a vacuum chamber of the PVD coating equipment.

In the present invention, the Al2O3 coating is fabricated by bipolar pulsed DMS technique or dual magnetron sputtering conductive Al2O3 ceramic target. In bipolar pulsed DMS technique, a symmetrical bipolar pulsed power is applied on the cathode target. The material of the cathode is pure Al target. The Al2O3 layer is fabricated by reactive sputtering of Al target in 02 gas with process pressure of 0.1-2 Pa at substrate temperature of 300-700°C. In dual magnetron sputtering conductive Al2O3 ceramic targets technique, an asymmetrical bipolar pulsed power with reversed positive voltage is applied on the cathode target. The material of the cathode is a conductive A1203 ceramic target that is made by adding conductive materials. The conductive additives include metal, such as Al, Ti, Cr, Nb, Pt, etc., and conductive ceramic, such as SiC, TiC, TiN, TiCN, TiB2, etc., whose content is 0.1-20wt% in the ceramic target. During deposition, The pressure of Ar gas or a gas mixture of Ar and 02 is 0.1-2 Pa, the substrate temperature is 300-700°C. A bipolar pulsed power is applied, with positive and negative bias voltage in the range of 20-50V and 20-300V, respectively. According to different deposition temperature, the amorphous or nanocrystalline Al2O3 coating can be obtained. Generally, when the substrate temperature is 300-500°C, the coating phase is mainly amorphous phase, when the substrate temperature is 500-700 °C, the coating phase is main nanocrystalline. The thickness of the Al2O3 coatings can be adjusted by controlling the deposition time.

Nitride coatings are obtained by reactive sputtering one or more metal or alloy target in N2 or Ar+Ni atmosphere, the gas pressure is 0.1-2pa, and substrate temperature is 300-700°C during the deposition process. In all the above cases, an asymmetrical bipolar pulsed power with reversed positive voltage (about 2-20% of the negative voltage) is applied as a bias voltage. During plasma etching, the negative bias voltage and the duty cycle is in the range of 300-1200V, 5-60%, respectively. During deposition, the negative bias voltage, the duty cycle ratio is in the range of 20-300V, 10-70%, respectively.

### The three coatings in the present invention:

(1) The coating layer consisting of single Al2O3 coating layer with thickness of 1-10µm. The Al2O3 coating layer mainly serves as the thermal and chemical barriers, promising the stability of the strength of blades during turning process.
(2) Multilayer coatings. The coating layer consists of at least two layers (i.e. a hard nitride layer and an A1203 coating layer). In this coating structure, the Al2O3 coating layer provides the thermal and chemical barrier, beneath which is a hard nitride interlayer adjacent to the substrate, which can provide the high hardness, excellent strength and adhension between the coating and the substrate in the temperature range of 600-1200 °C. Meanwhile the coating serves as the transition interlayer from the substrate to the A1203 coating layer, in order to adjust the distribution of internal stress and improve anti-fatigue performance.
(3) Multilayer or nanomultilayer coatings. It is obtained by hard nitride layers and Al2O3 layers alternately deposition. There are 4 to tens of hundreds of alternative hard nitride layer and A1203 coating layer with thickness range of 5-20 nm to several µm. The A1203 coating layer mainly serves as the thermal and chemical barriers, promising the stability of the strength of blades during turning process. More frequently, there is a gold TiN top layer for identifying the wear of coated cutting tools by naked eyes during machining process. The thickness of the hard nitride layer, A1203 layer, and TiN layer is in the range of 1-10 µm, 1-10 µm, and 1-2 µm, respectively. The thickness of the Al2O3 layer and nitride layer is controlled by controlling the deposition time.

### EXAMPLES

### Example 1

Si₃N₄ based ceramic cutting insert (with 5wt% TiN and 5wt% Y₂O₃ as additives) is used as substrate. Before being placed into the vacuum chamber for coating deposition, the inserts are grounded and polished to obtain a mirror like surface followed by ultrasonically cleaning in acetone and methanol bath sequentially before dried in N₂. The system was evacuated to a pressure below 5x10⁻³Pa and the substrate is heated to 450°C. Then the surface of the cutting inserts are plasma cleaned and etched utilizing a high-frequency bipolar pulsed bias voltage for 30 min, at an Ar gas process pressure of 3 Pa. During plasma etching, the negative bias voltage and the duty cycle are 800V and 30%, respectively.

A single layer of Al₂O₃ coating with thickness of 3µm is deposited utilizing reactive sputtering by bipolar pulsed DMS technique. A symmetrical bipolar pulsed power is applied on the pure Al cathode target. The Al₂O₃ layer is fabricated by reactive sputtering of Al target in a gas mixture of Ar and Oxygen with pressure of 0.5Pa at substrate temperature of 450 °C. During deposition, the positive and negative bias voltage is held at 30V and 200V, respectively. The frequency is 80 kHz while the duty cycle ratio is 40%.

### Example 2

Example 1 is repeated by coating Al₂O₃ single layer on Si₃N₄ based ceramic inserts (with 10wt% TiN and 5 wt % Y₂O₃ as additives).

### Example 3

Example 1 is repeated by coating Al₂O₃ single layer on Si₃N₄ based ceramic inserts (with 15wt% TiN and 5 wt % Y₂O₃ as additives).

### Example 4

Example 1 is repeated by coating Al₂O₃ single layer on Si₃N₄ based ceramic inserts (with 5wt% TiCN and 5wt% Y₂O₃ as additives).

### Example 5

A layer of 3µm Al₂O₃ coating is deposited on the Si₃N₄ based ceramic inserts (with 5wt% TiN+5wt%Y₂O₃ as additives) by dual magnetron sputtering conductive Al₂O₃ ceramic targets. The conductive Al₂O₃ ceramic targets are made by sintering Al₂O₃ powders with 5wt% pure metal Cr powder. The surface treatment before the deposition is applied using the same method as example 1.

The Al₂O₃ layer is fabricated by sputtering of conductively doped Al₂O₃ target in a gas mixture of 70% Ar and 30% O₂. The substrates temperature during the deposition is 450°C with the process pressure of 0.5Pa.

### Example 6

A layer of 3µm Al₂O₃ coating is deposited on the Si₃N₄ based ceramic inserts (with 10 wt % TiN and 5wt% Y₂O₃ as additives) by dual magnetron sputtering conductive Al₂O₃ ceramic targets (with 5wt% pure metal Cr as additive), using the same method as example 5.

### Example 7

A layer of 3µm Al₂O₃ coating is deposited on the Si₃N₄ based ceramic inserts (with 15 wt % TiN and 5wt% Y₂O₃ as additives) by dual magnetron sputtering conductive Al₂O₃ ceramic targets (with 5wt% pure metal Cr as additive), using the same method as example 5.

### Example 8

A layer of 3µm Al₂O₃ coating is deposited on the Si₃N₄ based ceramic inserts (with 5 wt % TiCN and 5wt% Y₂O₃ as additives) by dual magnetron sputtering conductive Al₂O₃ ceramic targets (with 5wt% pure metal Cr as additive), using the same method as example 5.

### Example 9

A layer of 3µm Al₂O₃ coating is deposited on the Si₃N₄ based ceramic inserts (with 5 wt % TiN and 5wt% Y₂O₃ as additives) by dual magnetron sputtering conductive Al₂O₃ ceramic targets (with 3wt% pure metal Cr powder as additive), using the same method as example 5.

### Example 10

A layer of 3µm Al₂O₃ coating is deposited on the Si₃N₄ based ceramic inserts with 5wt % TiN and 5wt% Y₂O₃ by dual magnetron sputtering conductive Al₂O₃ ceramic targets (with 1wt% pure metal Cr powder as additive), using the same method as example 5.

### Example 11

A layer of 3µm Al₂O₃ coating is deposited on the Si₃N₄ based ceramic inserts with 5wt % TiN and 5wt% Y₂O₃ by dual magnetron sputtering conductive Al₂O₃ ceramic targets (with 5 wt% pure Pt metal powder as additive), using the same method as example 5.

### Example 12

A layer of 3µm Al₂O₃ coating is deposited on the Si₃N₄ based ceramic inserts with 5wt % TiN and 5wt% Y₂O₃ by dual magnetron sputtering conductive Al₂O₃ ceramic targets (with 5 wt% SiC powder as additive), using the same method as example 5.

### Example 13

A coating consisting of 3.0µm TiN +3.0µm Al₂O₃ +1.0µmTiN is deposited by PVD on Si₃N₄ based ceramic inserts. The TiN layer is fabricated by reactive sputtering of Ti target in N₂ with process pressure of 1Pa at substrate temperature of 400°C. An asymmetrical bipolar pulsed power with reversed positive voltage of 20V is applied as a bias voltage.

### Example 14

A coating consisting of 3.0µm TiN +3.0µm Al₂O₃+1.0µm TiN is deposited by PVD on Si₃N₄ based ceramic inserts (with 5%wt TiN+5wt% Y₂O₃ as additives). The deposition of TiN layer is made by approach employed in Example 13 while the fabrication of Al₂O₃ layer is made by approach employed in Example 5.

### Example 15

A coating consisting of 3.0µm TiAIN +3.0µm Al₂O₃ + 1.0µm TiN is deposited by PVD on Si₃N₄ based ceramic inserts (with 5%wt TiN+5wt% Y₂O₃ as additives). The fabrication of Al₂O₃ layer is according to the Example 1. The TiAIN layer is fabricated by reactive sputtering of TiAl target in N₂ with process pressure of 1Pa at substrate temperature of 400°C. An asymmetrical bipolar pulsed power with reversed positive voltage of 20V is applied as a bias voltage. During the deposition, the negative bias voltage is 200V, and the duty cycle ratio is 30%. The deposition of the top TiN layer is made by approach employed in Example 13.

### Example 16

A coating consisting of 3.0µm TiAlN+ 3.0µm Al₂O₃ +1.0µmTiN is deposited by PVD on Si₃N₄ based ceramic inserts (with 5%wt TiN+5wt%Y₂O₃ as additives). The fabrication of Al₂O₃ layer is according to the Example 5. The fabrication of TiAlN and TiN layers are made by approach employed in Example 11 and Example 13, respectively.

### Example 17

A coating consisting of 2.0µm TiAlN+3.0µm Al₂O₃ +1.0µmTiN is deposited by PVD on Si₃N₄ based ceramic inserts (with 5%wt TiN+5wt% Y₂O₃ as additives). The fabrication of Al₂O₃ layer is according to the Example 5. The fabrication of TiAlN and TiN layers are made by approach employed in Example 11and Example 13, respectively.

### Example 18

A coating consisting of 2.0µm TiAlN+4.0µm Al₂O₃ +1.0µmTiN is deposited by PVD on Si₃N₄ based ceramic inserts (with 5%wt TiN+5wt% Y₂O₃ as additives). The fabrication of Al₂O₃ layer is based on Example 5. The fabrication of TiAIN and TiN layers are made by approach employed in Example 11 and Example 13, respectively.

### Example 19

Multilayer coating consisting of 20 alternative thin layers of TiAIN and Al₂O₃ with thickness of 1.0µ each is fabricated by PVD technique on Si₃N₄ based ceramic inserts (with 5%wt TiN+5wt% Y₂O₃ as additives). The deposition of TiAIN and Al₂O₃ are made by approaches employed in Example 15 and Example 1, respectively. Finally, a top layer of TiN with thickness of 1.0µm is coated on the multilayered coating using the approach employed in Example 13.

### Example 20

Multilayered coating consisting of 20 alternatively thin layers of TiAIN and Al₂O₃ with thickness of 1.0µm each is fabricated by PVD technique on Si₃N₄ based ceramic inserts (with 5%wt TiN+5wt% Y₂O₃ as additives). The deposition of TiAIN and Al₂O₃ are made by approaches employed in Example 15 and Example 5, respectively. Finally, a top layer of TiN with thickness of 1.0µm is coated on the multilayered coating using the approach employed in Example 13.

### Example 21

Multilayered coating consisting of 20 alternatively thin layers of TiAIN and Al₂O₃ with thickness of 0.5µm each is fabricated by PVD technique on Si₃N₄ based ceramic inserts (with 5%wt TiN+5wt% Y₂O₃ as additives). The deposition of TiAIN and Al₂O₃ are made by approaches employed in Example 15 and Example 1, respectively. Finally, a top layer of TiN with thickness of 1.0µm is coated on the multilayered coating using the approach employed in Example 13.

### Example 22

Multilayer coating consisting of 20 alternatively thin layers of TiAIN and Al₂O₃ with thickness of 0.3µm each is fabricated by PVD technique on Si₃N₄ based ceramic inserts (with 5%wt TiN+5wt% Y₂O₃ as additives). The deposition of TiAIN and Al₂O₃ are made by approaches employed in Example 15 and Example 1, respectively. Finally, a top layer of TiN with thickness of 1.0µm is coated on the multilayered coating using the approach employed in Example 13.

### Example 23

Multilayer coating consisting of 20 alternatively thin layers of TiAIN and Al₂O₃ with thickness of 10nm each is fabricated by PVD technique on Si₃N₄ based ceramic inserts (with 5%wt TiN+5wt% Y₂O₃ as additives). The deposition of TiAIN and Al₂O₃ are made by approaches employed in Example 15 and Example 1. Finally, a top layer of TiN with thickness of 1.0µm is coated on the multilayered coating using the approach employed in Example 13.

### Example 24

Multilayer coating consisting of 100 alternatively thin layers of TiAIN and Al₂O₃ with thickness of 10nm each is fabricated by PVD technique on Si₃N₄ based ceramic inserts (with 30%wt TiN as additive). The deposition of the alternatively thin layers is made by approach employed in Example 21. Finally, a top layer of TiN with thickness of 1.0µm is coated on the multilayered coating using the approach employed in Example 13.

### Example 25

Multilayer coating consisting of 50 alternatively thin layers of TiAIN and Al₂O₃ with thickness of 20nm each is fabricated by PVD technique on Si₃N₄ based ceramic inserts (with 5%wt TiN+5wt% Y₂O₃ as additives). The deposition of the alternatively thin layers is made by approach employed in Example 17. Finally, a top layer of TiN with thickness of 1.0µm is coated on the multilayered coating using the approach employed in Example 13.

### Example 26

Multilayer coating consisting of 50 alternatively thin layers of TiAIN and Al₂O₃ with thickness of 10nm each is fabricated by PVD technique on Si₃N₄ based ceramic inserts (with 5%wt TiN+5wt% Y₂O₃ as additives). The deposition of the alternatively thin layers is made by approach employed in Example 21. Finally, a top layer of TiN with thickness of 1.0µm is coated on the multilayered coating using the approach employed in Example 13.

### Example 27

Multilayered coating consisting of 50 alternatively thin layers of TiAIN and Al₂O₃ with thickness of 15nm each is fabricated by PVD technique on Si₃N₄ based ceramic inserts (with 5%wt TiN+5wt% Y₂O₃ as additives). The deposition of the alternatively thin layers is made by approach employed in Example 17. Finally, a top layer of TiN with thickness of 1.0µm is coated on the multilayered coating using the approach employed in Example 13.

### Example 28

Multilayered coating consisting of 50 alternatively thin layers of TiAIN and Al₂O₃ with thickness of 25nm each is fabricated by PVD technique on Si₃N₄ based ceramic inserts (with 5%wt TiN+5wt% Y₂O₃ as additives). The deposition of the alternatively thin layers is made by approach employed in Example 21. Finally, a top layer of TiN with thickness of 1.0µm is coated on the multilayered coating using the approach employed in Example 13.

### Example 29

Multilayered coating consisting of 50 alternatively thin layers of TiAIN and Al₂O₃ with thickness of 15nm each is fabricated by PVD technique on Si₃N₄ based ceramic inserts (with 30 wt % TiN as additive). The deposition of the alternatively thin layers is made by approach employed in Example 21. Finally, a top layer of TiN with thickness of 1.0µm is coated on the multilayered coating using the approach employed in Example 13.

### Example 30

Multilayered coating consisting of 50 alternatively thin layers of TiAlN and Al₂O₃ with thickness of 15nm each is fabricated by PVD technique on Si₃N₄ based ceramic inserts (with 30 wt % TiN as additive). The deposition of the alternatively thin layers is made by approach employed in Example 17. Finally, a top layer of TiN with thickness of 1.0µm is coated on the multilayered coating using the approach employed in Example 13.

## Claims

1. An Al₂O₃ coated Si₃N₄ cutting tool comprising a Si₃N₄ based substrate body and a coating layer on the substrate body, the feature of which includes Si₃N₄-based ceramic cutting tool substrate and at least one Al₂O₃ coating layer consisting of one-layered Al₂O₃ or Al₂O₃-contained coatings.

2. The Si₃N₄ ceramic cutting tool substrate of claim 1, wherein the Si₃N₄-based composite comprises the first Si₃N₄, the toughening addtive and sintering addtive.

3. The toughening agent of claim 2, wherein the toughening agent is one or several material of the following ceramics: TiN, TiC, MoSi₂, SiC, TiCN, TiB₂, MoSi₂.

4. The toughening agent of claim 2, wherein the toughening agent makes the insulative Si₃N₄ conductive and the content of the conductive and toughening agent is 0.1wt%-5wt%.

5. The sintering additive of claim 2, wherein the sintering additive is one or several among the following materials: SiO₂, Al₂O₃, MgO, Y₂O₃, ZrO₂, ReO (rare earth oxide, i.e. La₂O₃).

6. The sintering additive of claim 2, wherein the content of the sintering additive is 0.1wt-25wt% and the optimal content is 1wt-5wt%

7. The Si₃N₄-based ceramic cutting tool of claim 1, wherein the density of the Si₃N₄-based composite is greater than 98% of the the theoretical density. The composite ceramic is prepared by conventional sintering approaches such as pressureless sintering, hot sintering, atmosphere sintering and hot isostatic pressing. The sintering approaches include but not only oxygen-free atomosphere.

8. The Al₂O₃ coated Si₃N₄-based ceramic cutting tool of claim 1, wherein the coating is hard nitride coating, Al₂O₃ coating and TiN coating on the surface respectively from the interface of substrate and coating to outer surface of the coating.

9. The Al₂O₃ coated Si₃N₄ cutting tool of claim 1, wherein the thickness of inner coating hard nitride is 1-20µm and the optimal thickness is 1-10µm.

10. The Al₂O₃ coated Si₃N₄ cutting tool of claim 1, wherein the coating contains at least one-layer stoichiometric non-crystal, nano-crystal or non-crystal and nano-crystal mixed Al₂O₃ coating.

11. The Al₂O₃ coated Si₃N₄ cutting tool of claim 1, wherein before the coating layer is deposited, the substrate body is grounded or polished or gently wet/dry blasted and cleaned.

12. The Al₂O₃ coated Si₃N₄ cutting tool of claim 1, wherein before deposition process plasma cleaning and etching by plasma etching are adopted utilizing a high-frequency bipolar pulsed bias voltage or an ion source for 2-60 min, preferably for 5-30 min, at an Ar gas or a gas mixture of Ar and O₂ with process pressure of 0.1-10 Pa.

13. The Al₂O₃ coated Si₃N₄ cutting tool of claim 1, wherein a base pressure of 10⁻⁴-10⁻²Pa of the vacuum chamber is adopted during the deposition process.

14. The Al₂O₃ coated Si₃N₄ cutting tool of claim 1, wherein the Al₂O₃ coating layer is deposited utilizing reactive sputtering by bipolar pulsed DMS technique or dual magnetron sputtering conductive Al₂O₃ ceramic target formed by doping conductive material in Al₂O₃.

15. The Al₂O₃ coated Si₃N₄ cutting tool of claim 1 and 14, wherein the Al₂O₃ coating layer is deposited reactive sputtering of Al cathode utilizing bipolar pulsed DMS technique in an O₂ gas or a gas mixture of Ar and O₂ with process pressure of 0.1-2 Pa at substrate temperature of 300-700°C by bipolar pulsed DMS technique.

16. The Al₂O₃ coated Si₃N₄ cutting tool of claim 1 and 14, wherein the Al₂O₃ coating layer is deposited by sputtering conductive Al₂O₃ ceramic target via DMS technique in an Ar gas or a gas mixture of Ar and O₂ with process pressure of 0.1-2 Pa at substrate temperature of 300-700°C.

17. The Al₂O₃ coated Si₃N₄ cutting tool of claim 16, wherein the conductive Al₂O₃ ceramic target consists of Al₂O₃ and 0.3-20 wt% doping material comprising Al, Ti, Cr, Nb, Pt or SiC.

18. The Al₂O₃ coated Si₃N₄ cutting tool of claim 1 or 14, wherein the hard nitride layer consists of binary nitrides such as TiN and CrN, ternery nitrides such as TiCN, or polarbasic nitrides such as CrTiSiN, TiAlSiN and TiAlCrYN layer or their multi-layers or nano layers.

19. The Al₂O₃ coated Si₃N₄ cutting tool of claim 1 or 14, wherein the coating consists of a a TiN top layer with the thickness of 1-2µm, a hard nitride layer with thickness of 1-10 µm and an Al₂O₃ coating layer with thickness of 1-10 µm.

20. The Al₂O₃ coated Si₃N₄ cutting tool of claim 1, wherein the coating consists of multilayer hard nitride via alternate deposite technique, Al₂O₃ and TiN coating on its surface.

21. The Al₂O₃ coated Si₃N₄ cutting tool of claims 20, wherein the coating layer consists of 4 to tens of hundreds of alternating layers of hard nitride layers and Al₂O₃ layers with respective thickness of 5-20 nm to 0.5-1.0 µm. The coating layer has a TiN top layer with thickness of 1-2µm on the surface of the coating layer.

22. The Al₂O₃ coated Si₃N₄ cutting tool of claim 1, wherein the hard nitride layer is fabricated by reactive sputtering of one or more targets of Ti, Al, Cr, Si, TiAl, TiSi, AlCr, TiAlCr or TiAlY in an N₂ gas or a gas mixture of Ar and N₂ with process pressure of 0.1-2 Pa at substrate temperature of 300-700°C.

23. The Al₂O₃ coated Si₃N₄ cutting tool of claim 21, wherein the coating layer consists of 4 to a thousand of alternating layers of hard nitride layers and Al₂O₃ layers with respective thickness of 5-20 nm to several micrometers.
